Europäisches Patentamt

European Patent Office

Office européen des brevets

(11) Veröffentlichungsnummer: **0 184 609**
**B1**

(12) **EUROPÄISCHE PATENTSCHRIFT**

(45) Veröffentlichungstag der Patentschrift:
12.10.88

(21) Anmeldenummer: **85109634.7**

(22) Anmeldetag: **31.07.85**

(51) Int. Cl.⁴: **G 01 R 1/20, H 01 C 1/16**

(54) Anordnung zum Erfassen eines Stromes durch einen Widerstand.

(30) Priorität: **09.11.84  DE 3440986**

(43) Veröffentlichungstag der Anmeldung:
**18.06.86 Patentblatt 86/25**

(45) Bekanntmachung des Hinweises auf die Patenterteilung:
**12.10.88 Patentblatt 88/41**

(84) Benannte Vertragsstaaten:
**DE FR IT**

(56) Entgegenhaltungen:
**DE-A-2 501 824**
**DE-A-3 323 905**
**GB-A-2 106 275**

(73) Patentinhaber: **ANT Nachrichtentechnik GmbH,
Gerberstrasse 33, D-7150 Backnang (DE)**

(72) Erfinder: **Ohms, Franz, Dipl.- Ing., Schwabstrasse
4, D-7153 Weissach im Tal (DE)**

**Beschreibung**

Die Erfindung betrifft eine Anordnung nach dem Oberbegriff der Anspruchs 1 zum Erfassen eines Stromes durch einen Widerstand. Solche Anordnungen sind beispielsweise bekannt aus der älteren nicht vorveröffentlichten DE-A-3 323 905 und aus der DE-A-2 822 897 oder DE-A-2 339 856.

Bei der DE-A-2 39 856 ist zum Erfassen eines Stromes ein Strommeßwandler vorgesehen, der mit einem gegengekoppelten Operationsverstärker beschaltet ist. Mit einer solchen Anordnung sind nur Wechselströme und keine Gleichströme erfassbar. Für eventuelle Änderungen der elektrischen Eigenschaften infolge Temperaturdrift sind keine Maßnahmen vorgesehen. Bei der DE-A-2 822 897 wird ein Strom durch eine Brückenschaltung, bestehend aus drei Widerständen und einem gegengekoppelten Operationsverstärker erfasst. Temperaturdriften werden durch eine temperaturabhängigen Bezugsspannung berücksichtigt. Bei der älteren nicht vorveröffentlichten DE-A-3 323 905 (veröffentlicht aus 10.1. 1985) wird zur Stromerfassung eine Drossel herangezogen. Diese weist eine zusätzliche Meßwicklung auf, die bezüglich der Hauptwicklung so angeordnet und mit einer Vergleichsstufe beschaltet ist, daß Temperaturabhängigkeiten bei der Stromerfassung keinen Einfluß auf das Meßergebnis haben. Die Anordnung gemäß DE-A-3 323 905 ist zur Erfassung von Gleich- und Wechselströmen geeignet.

Aufgabe der Erfindung ist es, eine Anordnung zum Erfassen eines Stromes durch einen Widerstand anzugeben, wobei dieser Strom ein Gleich-, Wechsel- oder Gemischtstrom sein kann, die keine Verfälschung dieses Stromes, insbesondere durch Temperatureinflüsse, mit sich führt. Außerdem soll eine Verwendung dieser Anordnung aufgezeigt werden. Diese Aufgabe wird bezüglich der Anordnung durch die Merkmale des Patentanspruchs 1 und bezüglich der Verwendung durch die Merkmale des Patentanspruchs 4 gelöst. Die Unteransprüche zeigen Vorteilhafte Ausgestaltungen der Anordnung auf.

Besonders vorteilhaft ist es, daß bei der Erfindung neben den Temperatureinflüssen auch induktive Spannungseinflüsse bei der Erfassung hochfrequenter Wechselstromanteile kompensiert werden.

Aus der DE-A-2 501 824 sind temperaturkompensierte Wiederstände bekannt, bei dessen Materialien mit zwei unterschiedlichen Temperaturkoeffizienten zum Einsatz gelangen.

Anhand der Zeichnungen wird die Erfindung nun näher erläutert. Es zeigen

Fig. 1 ein Vereinfachtes elektrisches Ersatzschaltbild der Anordnung,

Fig. 2 eine Aufsicht auf die thermisch gekoppelten Leiter der Widerstände,

Fig. 3 eine Schnittdarstellung hierzu und

Fig. 4 ein Ersatzschaltbild unter Berücksichtigung parasitärer Effekte.

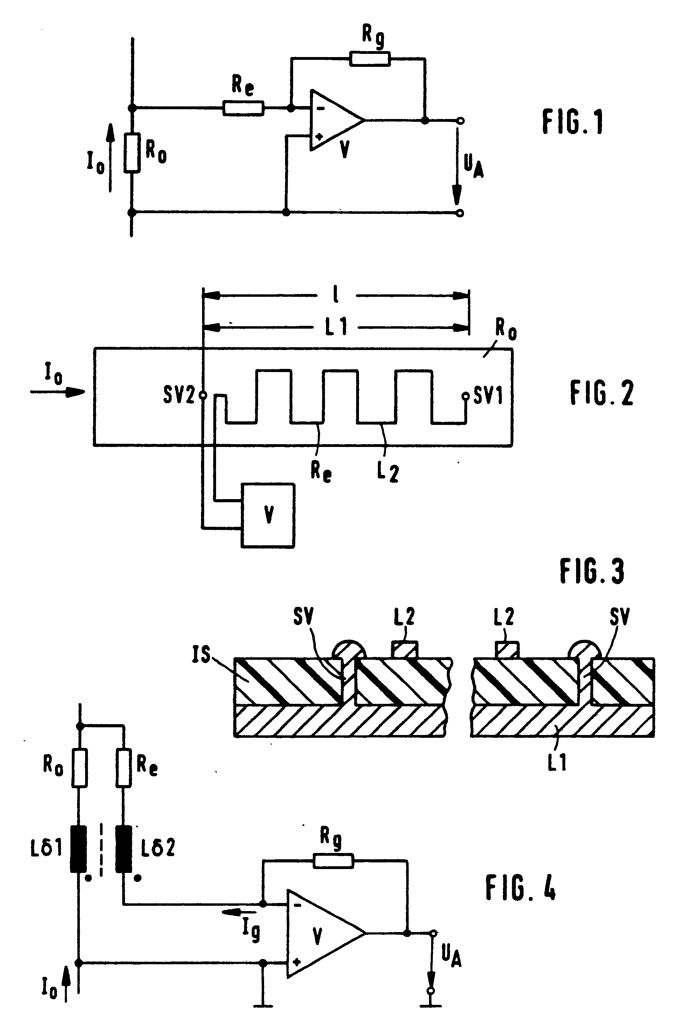

Das vereinfachte elektrische Ersatzschaltbild gemäß Fig. 1 zeigt den Widerstand $R_O$ durch den der zu erfassende Strom $I_0$ fließt. Ein Ende des weiteren Widerstandes $R_e$ ist mit einem Ende des Widerstandes $R_O$ verbunden. Die beiden nicht verbundenen Enden der Widerstände $R_e$ und $R_O$ führen jeweils zu einem Eingang einer Vergleichseinrichtung V. Diese Vergleichseinrichtung V besteht aus einem mittels Widerstand $R_g$ gegengekoppelten Operationsverstärker. Der Widerstand $R_e$ ist an den invertierenden Eingang und der Widerstand $R_O$ an den nichtinvertierenden Eingang des gegengekoppelten Operationsverstärkers angeschlossen. Am Ausgang A des Operationsverstärkers erscheint dann eine Spannung

$$U_A = R_O \cdot \frac{R_g}{R_e} \cdot I_O,$$

die proportional zum zu erfassenden Strom $I_O$ ist.

Die Figuren 2 und 3 zeigen die Anordnung der Leiter L1 und L2 der Widerstände $R_O$ und $R_e$ in einer Aufsicht und in einer Schnittdarstellung. Der Leiter L1 des Widerstandes $R_O$ besteht aus einer Metallfolie, die eine wesentlich größere Längsausdehnung als eine Querausdehnung aufweist und die auf einer Seite einer homogenen Isolierschicht IS aufgebracht ist. Auf der anderen Seite dieser Isolierschicht ist der Leiter L2 des weiteren Widerstandes $R_e$ mäanderförmig aufgebracht; seine Gesamtlänge ist also größer als die thermische Koppellänge mit dem Leiter L1. Über die Isolierschicht IS sind die beiden Leiter L1 und L2 thermisch gekoppelt. Die Leiter L1 und L2 bestehen aus gleichem Material; d. h. sie weisen zumindest gleichen spezifischen Widerstand und gleiches Temperaturverhalten auf. Die einen Enden der Leiter L1 und L2 sind über eine Schweißverbindung SV1 miteinander verbunden. Das nicht mit $R_e$ verbundene Ende des Leiters L1 ist über eine Schweißverbindung SV2 mit der Zuleitung zur Vergleichsstufe verbunden.

Im Ersatzschaltbild der Anordnung gemäß Fig. 4 sind parasitäre Effekte berücksichtigt. Im Unterschied zu dem Ersatzschaltbild gemäß Fig. 1 zeigt Fig. 4 die parasitären Induktivitäten $L\sigma1$ und $L\sigma2$ der Widerstände $R_O$ und $R_e$ zum Operationsverstärker V. Die induktive Spannung an der Induktivität $L\sigma1$ des Widerstandes $R_O$, die sich bei höherfrequenten Strömen $I_O$ bemerkbar macht, wird durch die phasenentgegengesetzte induktive Meßspannung an der parasitären Induktivität $L\sigma2$ des Widerstandes $R_e$ kompensiert.

Auf das Ersatzschaltbild gemäß Fig. 4 wird nun die Maschenanalyse angewendet. Es gilt dann:

$$I_g \cdot R_e = (I_O - I_g) \cdot R_O$$

$$I_g = \frac{R_O}{R_e + R_O} \cdot I_O$$

Die Ausgangsspannung $U_A$ ergibt sich dann zu:

$$U_A = \frac{R_0}{R_e + R_0} \cdot R_g \cdot I_0 \qquad\qquad\qquad (a)$$

Die Widerstände $R_O$ and $R_e$ werden nun als Funktion des Widerstandsbelages $R_{O(1)}$ bzw. $R_{e(1)}$ dargestellt und in letztere Beziehung eingesetzt.

Es gilt

$$R_0 = \int_0^1 R'_{0(1)} \, dl \qquad und \qquad R_e = \int_0^1 R'_{e(1)} \, dl$$

wobei 1 die Koppellänge der Leiter bezeichnet.
Mit der Temperaturabhängigkeit der Widerstandsbeläge

$$R_{O'(1)} = R'_O \,|\, T=T_0 \cdot [\,1 + k\,\vartheta\,(T_{(1)} - T_0)\,]$$

und

$$R'_{e(1)} = R_{e'} \,|\, T=T_0 \cdot [1 + k\,\vartheta\,(T_{(1)} - T_0)\,]$$

wobei mit $k\,\vartheta$ der Widerstandstemperaturkoeffizient bezeichnet ist, erhält man

$$R_0 = R'_0 \,\Big|_{T=T_0} \cdot \int_0^1 \big[\,1 + k \quad (T_{(1)} - T_0)\,\big] \, dl$$

und

$$R_e = R'_e \,\Big|_{T=T_0} \cdot \int_0^1 \big[\,1 + k \quad (T_{(1)} - T_0)\,\big] \, dl.$$

Setzt man diese beiden letzten Beziehungen in die Beziehung (a) ein so gilt:

$$U_A = \frac{R_{0'}}{R_e + R_{0'}} \cdot R_g \cdot I_0.$$

Es ergibt sich also eine optimale Temperaturkompensation, wenn die thermische Kopplung derart erfolgt, daß sich die Widerstandsbeläge $R_{0'}$ und $R_{e'}$ über der betrachteten Koppellänge 1 nicht ändern. Selbst ein eventueller Temperaturgradient längs der Koppellänge 1 wird kompensiert.

Es können mit der erfindungsgemäßen Anordnung Strommeßeinrichtungen höchster Präzision relativ einfach aufgebaut werden. Meßfehler können nur noch entstehen durch unterschiedliche Temperaturen der Widerstände $R_0$ und $R_e$, beispielsweise hervorgerufen durch einen schlechten Wärmeaustausch über die Isolierschicht IS, sowie Differenzen im Widerstandstemperaturkoeffizient $k\,\vartheta$. Unterschiede im Widerstandstemperaturkoeffizienten $k\,\vartheta$ rühren von Verunreinigungen sowie Fehlern in der Atomgitterstruktur her, z. B. durch unterschiedliche Bearbeitung.

Die erfindungsgemäße Anordnung läßt sich vorteilhaft für gedruckte Schaltungen anwenden. Die Leiterplatte stellt dann die notwendige Isolierschicht Is dar und die Widerstände können aus der Kupferkaschierung dieser Leiterplatte bestehen. Eine weitere andere Ausgestaltung besteht darin, daß die Isolierschicht IS aus einem flexiblen Folienträger gebildet ist, auf den beidseitig Metallfolien aufgeklebt sind.

**Patentansprüche**

1. Anordnung zum Erfassen eines Stromes durch einen Widerstand (R$_O$), mit einer Vergleichsstufe (V), deren Ausgang den Ausgang für ein Signal proportional zum erfaßten Strom (I$_O$) bildet, <u>dadurch gekennzeichznet,</u> daß der Leiter (L1) des Widerstandes (R$_O$) mit dem Leiter (L2) eines weiteren Widerstandes (R$_e$) thermisch gekoppelt ist, daß beide Leiter (L1, L2) gleiche Materialeigenschaften mindestens bezüglich ihres spezifischen Widerstandes und Temperaturverhaltens aufweisen, daß die beiden Leiter (L1, L2) derart ausgebildet und thermisch gekoppelt sind, daß sich ihre Widerstandsbeläge über der gesamten Kopplungslänge nicht ändern, daß ein Ende des einen Leiters mit einem Ende des anderen Leiters verbunden ist, daß die nicht miteinander verbundenen Enden der beiden Leiter (L1, L2) jeweils mit einem Eingang der Vergleichsstufe (V) verbunden sind.

2. Anordnung nach Anspruch 1, <u>dadurch gekennzeichnet,</u> daß der Leiter (L1) des Widerstandes (R$_O$) aus einer Metallfolie besteht, die eine wesentlich größere Längsausdehnung aufweist als ihre Querausdehnung beträgt, daß der Leiter (L2) des weiteren Widerstandes (R$_e$) folienartig ist und unter Zwischenlage einer homogenen Isolierschicht (IS) derart aufgebracht ist, daß die Flächennormalen der beiden folienartigen Leiter (L1, L2) übereinstimmen.

3. Anordnung nach Anspruch 1 oder 2, <u>dadurch gekennzeichnet,</u> daß der Verlauf des Leiters (L2) des weiteren Widerstandes (R$_e$) mäanderförmig ist.

4. Verwendung der Anordnung nach einem der Ansprüche 1 bis 3 für gedruckte Schaltungen, wobei die Isolierschicht (IS) aus einer Leiterplatte oder einem flexiblen Folienträger besteht, auf die/den die Leiter (L1, L2) der Widerstände (R1, R2) beidseitig aufgebracht sind.

**Claims**

1. A device for measuring a current by means of a resistor (R$_O$) with a comparator stage (V), the output of which forms the output for a signal proportional to the measured current (I$_O$), characterized in that the conductor (L1) of the resistor (R$_O$) is thermically coupled with the conductor (L2) of a further resistor (R$_e$), in that both conductors (L1, L2) have the same material characteristics, at least in regard to their specific resistance and temperature reaction, in that the two conductors (L1, L2) are designed and thermically coupled in such a way that their resistance loads per unit length do not change along their entire coupled length, in that one end of the one conductor is connected to an end of the other conductor, in that the non-connected ends of the two conductors (L1, L2) are each connected with an input of the comparator stage (V).

2. A device in accordance with claim 1, characterized in that the conductor (L1) of the resistor (R$_O$) consists of a metal foil having a longitudinal extent which is considerably greater than its lateral extent, in that the conductor (L2) of the further resistor (R$_e$) is in the form of a foil and is applied, with the interposition of a homogenous insulating layer (IS), in such a way that the normals of the surfaces of the two foil-like conductors (L1, L2) coincide.

3. A device in accordance with claim 1 or 2, characterized in that the course of the conductor (L2) of the further resistor (R$_e$) is in the form of a meander.

4. Application of the device in accordance with one of claims 1 to 3 for printed circuits wherein the insulating layer (IS) consists of a printed circuit board or a flexible foil carrier on both sides of which the conductors (L1, L2) of the resistors (R1, R2) are applied.

**Revendications**

1. Agencement pour saisir un courant passant par une résistance (R$_O$), avec un étage comparateur (V) dont la sortie constitue la sortie d'un signal proportionnel au courant saisi (I$_O$), <u>caractérisé</u> par le fait que le conducteur (L1) de la réistance (R$_O$) est thermiquement couplé au conducteur (L2) d'une autre résistance (R$_e$), par le fait que les deux conducteurs (L1, L2) présentent les mêmes caractéristiques de matière, au moins pour ce qui est de leur résistivité et de leur comportement à la température, par le fait que les deux conducteurs (L1, L2) sont réalisés et couplés thermiquement de façon que leurs résistances linéiques ne varient pas sur l'ensemble de la longueur de couplage, par le fait qu'une extrémité du premier conducteur est connectée à une extrémité de l'autre conducour, par le fait que les extrémités non connectées des deux conducteurs (L1, L2) sont reliées chacune à une entrée de l'étage comparateur (V).

2. Agencement selon revendication 1, <u>caractérisé</u> par le fait que le conducteur (L1) de la résistance (R$_O$) consiste en une feuille métallique qui présente une étendue longitudinale sensiblement supérieure à son étendue transversale, par le fait que le conducteur (L2) de l'autre résistance (R$_e$) est du genre feuille et est rapporté, avec interposition d'une feuille isolante homogène (IS), de manière que les normales des deux conducteurs du genre feuille (L1, L2) coincident.

3. Agencement selon revendication 1 ou 2, <u>caractérisé</u> par le fait que le tracé du conducteur (L2) de l'autre résistance (R$_e$) est en forme de méandres.

4. Utilisation de l'agencement selon l'une des revendications 1 à 3, pour des circuits imprimés, dans lequel la couche isolante (IS) est constituée par une carte à circuit imprimé ou par un support en feuille flexible, sur les deux côtés de laquelle/duquel sont rapportés les conducteurs (L1, L2) des résistances (R1, R2).

FIG.1

FIG.2

FIG.3

FIG.4